Europäisches Patentamt

(19) European Patent Office

Office européen des brevets

(11) Numéro de publication: **0 073 421**
**B1**

(12) ## FASCICULE DE BREVET EUROPEEN

(45) Date de publication du fascicule du brevet:
13.11.85

(51) Int. Cl.⁴: **H 05 K 9/00**

(21) Numéro de dépôt: **82107579.3**

(22) Date de dépôt: **19.08.82**

(54) Dispositif de protection des objets métalliques situés dans l'environnement d'un grand champ magnétique développé par un rotor d'alternateur sans stator.

(30) Priorité: **25.08.81 FR 8116203**

(43) Date de publication de la demande:
**09.03.83 Bulletin 83/10**

(45) Mention de la délivrance du brevet:
**13.11.85 Bulletin 85/46**

(84) Etats contractants désignés:
**AT BE CH DE FR GB IT LI LU NL SE**

(56) Documents cités:
**DE - A - 2 945 144**

(73) Titulaire: **ALSTHOM-ATLANTIQUE Société Anonyme dite:, 38, avenue Kleber, F-75794 Paris Cédex 16 (FR)**

(72) Inventeur: **Delassus, Jean, 31, rue des Carrières, F-95160 Montmorency (FR)**
Inventeur: **Gey, Michel, 30, avenue de la République, F-78800 Houilles (FR)**
Inventeur: **Comensoli, Jean-Claude, 2, Résidence Jean-Sébastien Bach, F-95500 Gonesse (FR)**
Inventeur: **Pouger, Paul, 38, rue des Deux Ponts, F-93600 Aulnay Sous Bois (FR)**

(74) Mandataire: **Weinmiller, Jürgen et al, Zeppelinstrasse 63, D-8000 München 80 (DE)**

BUNDESDRUCKEREI BERLIN

## Description

La présente invention a trait à un dispositif de protection des objets métalliques situés dans l'environnement d'un grand champ magnétique développé par un rotor d'alternateur sans stator au cours d'essais lorsqu'il est parcouru par un courant d'excitation, comportant une enveloppe métallique en plusieurs parties entourant le rotor.

Il est en effet utile, lors des essais du rotor d'un alternateur, de l'alimenter par un courant d'excitation pour étudier le comportement mécanique du rotor lorsqu'il s'échauffe. Ces essais se font dans des fosses de survitesse qui comportent des glissières métalliques sur lesquelles coulissent les supports de paliers du rotor, ainsi que des ponts roulants.

Lorsque la fosse de survitesse est sous vide, elle comporte également une virole cylindrique en acier sur laquelle sont fixés les glissières et le pont roulant.

Or, lors de la rotation du rotor parcouri par un courant d'excitation, il se produit un grand champ magnétique radial tournant qui développe dans toutes les parties métalliques environnantes (support de paliers, glissières, pont roulant et éventuellement virole lorsqu'elle existe) des courants induits. La présence de ces courants développe des points chauds, ce qui entraîne des déformations rédhibitoires.

Il est connu du document DE-A 2 945 144 d'utiliser comme dispositif de protection une enveloppe métallique emprisonnant complétement le rotor et comprenant deux demi-enveloppes semi-cylindriques constituées chacune de segmente semi-cylindriques en tôle pleine assemblés par brides boulonnées, les deux demi-enveloppe étant en contact électrique suivant un plan de joint vertical et comportant à leurs extrémités des faces frontales en tôles pleines.

Dans le dispositif connu des pertes électriques importantes sont dégagées dans l'enveloppe massive et provoquent un échauffement qui peut conduire à des déformations de celle-ci.

De plus l'air emprisonné à l'intérieur de l'enveloppe s'échauffe lors de la rotation du rotor et celui-ci s'échauffe également, en l'absence de toute ventilation, jusqu'à des températures prohibitives. Le dispositif selon l'invention permettant d'éviter ces inconvénients comporte une enveloppe métallique qui est constituée par au moins une cage métallique formant un réseau maillé, chaque cage étant composée d'une demi-cage inférieure supportée par un socle et d'une demi-cage supérieure posée sur la demi-cage inférieure, les deux demi-cages étant assemblées dans un plan de joint horizontal, chaque demi-cage comprenant des éléments conducteurs de l'électricité horizontaux parallèles à l'axe du rotor réunis et soudés à des éléments conducteurs de l'électricité demi-circulaires, ladite cage ou lesdites cages placées bout à bout ayant une longueur supérieure à la partie du rotor produisant le champ magnétique, lesdits conducteurs horizontaux étant des tubes parcourus par une circulation d'eau et débouchant aux deux extrémités dans des demi-anneaux creux servant de collecteurs hydrauliques pour l'entrée et la sortie de l'eau de réfrigération.

Les cages selon l'invention arrêtent le champ magnétique; les pièces métalliques situées autour de la cage à une distance de l'ordre de grandeur de largeur des mailles sont protégées.

Grâce à la circulation d'eau les conducteurs électriques horizontaux sont refroidis.

Par ailleurs les cages maillées laisse passer l'air de ventilation entraîné par le rotor en rotation empêchant ainsi toute élévation prohibitive de la température du rotor.

De plus à travers les cages maillées on peut surveiller visuellement le rotor et intervenir sur le rotor lui-même au cours des contrôles nécessités par les tests.

Enfin le plan de joint des deux demi-cages étant horizontal le montage de ces demi-cages est facilité il n'est notamment pas nécessaire de disposer de moyens pour déplacer les demi-cages selon des directions horizontales perpendiculairement à l'axe du rotor.

Selon un mode de réalisation de l'invention, les deux demi-cages constituant chaque cage sont prolongées dans le plan de joint par deux épanouissements, lesdits épanouissements étant équipés de tubes auxiliaires débouchant dans des prolongements des demi-anneaux creux et étant entretoisés par des prolongements horizontaux des éléments conducteurs demi-circulaires, les épanouissements de la demi-cage supérieure étant séparés des épanouissements de la demi-cage inférieure par des moyens isolants électriques.

Ainsi les courants induits importants engendrés le long du plan de joint dans les deux demi-cages ne traversent pas le joint ce qui évite les problèmes de contact entre les deux demi-cages.

Pour serrer les deux demi-cages tout en les isolant on utilise de préférence des cales isolantes disposées entre les tubes des épanouissements et traversées des boulons métalliques assurant le serrage et sans contact avec les parties conductrices.

Pour assurer au mieux le refroidissement de chaque on utilise de préférence une circulation d'eau dans la demi-cage inférieure qui se fait du point bas d'un demi-anneau creux au point de l'autre demi-anneau creux puis dans la demi-cage supérieure d'un point bas d'un demi-anneau creux au point haut de l'autre demi-anneau creux, ledit point haut du demi-anneau de la demi-cage inférieure étant relié par une canalisation courte audit point bas du demi-anneau creux de la demi-cage supérieure.

Pour éviter que la demi-cage supérieure soit à un potentiel indéterminé, on la réunira à la demi-cage inférieure par une liaison électrique avec forte résistance qui ne laisse pas passer les variations de courant.

L'invention va maintenant être décrite plus en détail en se référant à un mode de réalisation particulier cité à titre d'exemple non limitatif et représenté par des dessins annexés.

La figure 1 représente une fosse de survitesse sous vide dans laquelle est disposé un rotor entouré du dispositif de protection selon l'invention.

La figure 2 représente une vue longitudinale d'une cage selon l'invention.

La figure 3 représente une coupe transversale d'une cage selon l'invention.

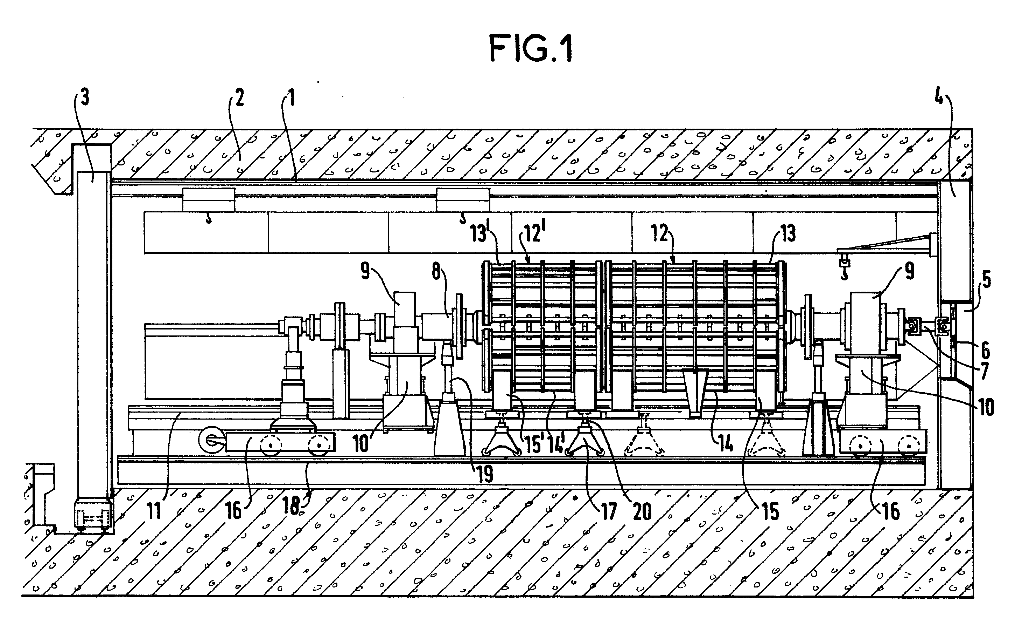

La fosse de survitesse représentée à la figure 1 comprend un tunnel horizontal comportant une virole cylindrique en acier 1 entourée de béton 2. Une porte 3 vient fermer hermétiquement l'ouverture gauche du tunnel.

L'ouverture droite du tunnel est fermée par une paroi 4 comportant une ouverture 5 munie d'un joint d'étanchéité 6 à travers lequel passe un arbre 7 pour entraîner le rotor 8 en rotation. L'axe du rotor 8 peut tourner sur des paliers 9 dont les supportes 10 reposent sur des glissières 11.

Le rotor 8 est entouré d'une première cage 12 et d'une seconde cage 12'. La cage 12 comprend une demi-cage supérieure 13 et une demicage inférieure. De même la cage 12' comprend une demi-cage supérieure 13' et une demi-cage inférieure 14'.

Les demi-cage inférieures 14, 14' sont solidaires de supports 15, 15' reposant sur la glissière 11. Les supports 10 des paliers 9 et les supports 15 et 15' des demi-cages inférieures sont amenés par des chariots mobiles 16, 17 à l'intérieur du tunnel puis sur les glissières.

Les chariots 16 roulent sur des rails 18 qui se prolongent hors du tunnel où l'équipage, constitué par le rotor, ses paliers avec leurs supports, les cages avec leurs supports, est assemblé.

Ensuite on roule les chariots 16 à l'intérieur du tunnel puis on dépose les supports 10 de palier sur les glissières 11 par l'intermédiaire des vérins des chariots 16. Les chariots mobiles 17 utilisés pour les supports 15, 15' des demi-cage inférieures comportent des vérins 20, qui lorsqu'ils sont abaissés de déposer les supports 15, 15' sur les glissières 11.

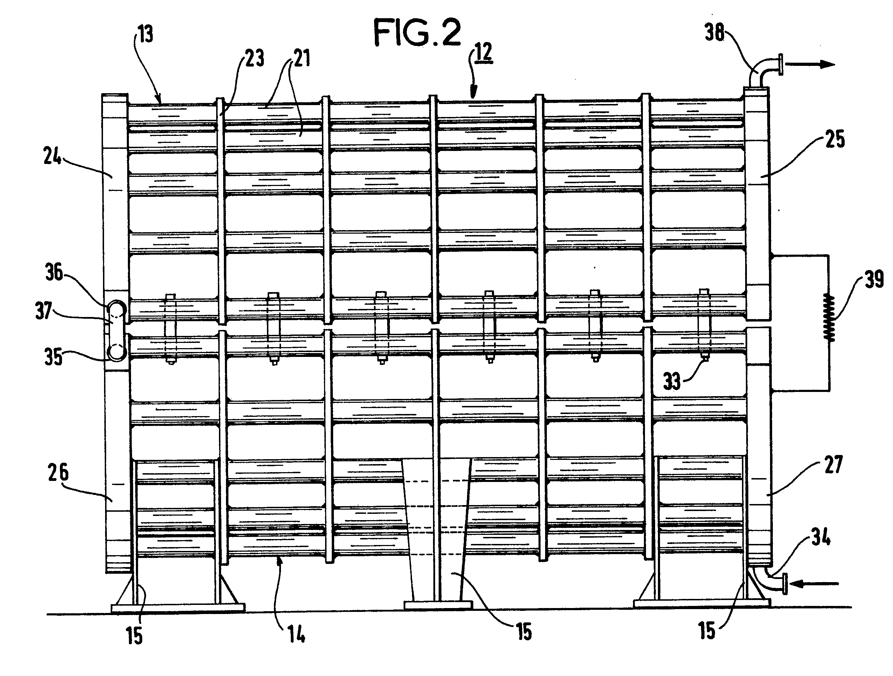

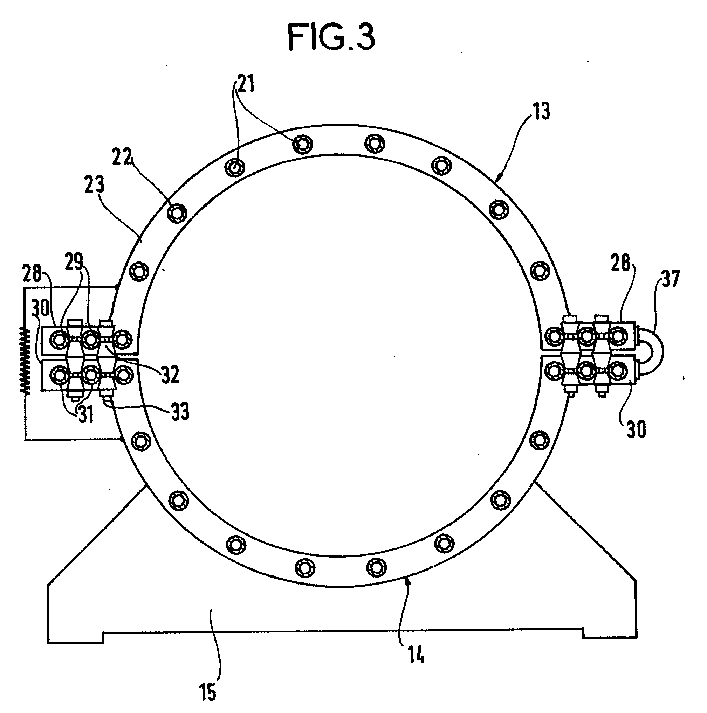

Chaque demi-cage (voir figures 2 et 3) comporte des tubes horizontaux 21 régulièrement répartis. Ces tubes passent à travers des trous 22 percés dans des éléments conducteurs 23 en forme de demi-cercle auxquels ils sont soudés sur leur pourtour. Les éléments conducteurs 23 en forme de demi-cercle sont en métal épais et donnent à la demi-cage sa rigidité mécanique. Aux deux extrémités des demi-cages sont disposés des demi-anneaux creux (24, 25 pour la demi-cage supérieure et 26, 27 pour la demi-cage inférieure) dans lesquels débouchent les tubes horizontaux.

La demi-cage supérieure 13 comporte dans le plan horizontal de joint deux épanouissements horizontaux 28. Ces épanouissements comportent chacun deux tubes horizontaux auxiliaires 29.

De même la demi-cage inférieure 14 comporte, dans le plan horizontal de joint, deux épanouissement horizontaux 30 qui comportent chacun deux tubes horizontaux auxiliaires 31.

Les tubes auxiliaires 29, 31, sont entretoisés par des prolongements horizontaux des éléments en forme de demi-cercle 23 et ils débouchent dans des prolongements horizontaux des demi-anneaux d'extrémité (24, 25 pour la demi-cage supérieure et 26, 27 pour la demi-cage inférieure).

Des cales trapézoïdales isolantes 32 sont coincées entre les tubes des épanouissements 28, 30 des deux demi-cages 13, 14 (c'est-à-dire les tubes auxiliaires 29, 31 et les tubes 21 situés dans le plan de joint), si bien que la demi-cage supérieure 13 repose sur la demi-cage inférieure 14 sans contact électrique entre les épanouissements 28, 30.

Les tubes des épanouissements supérieurs 28 sont placés à la verticale des tubes des épanouissements inférieurs 30 de façon à avoir un bon couplage magnétique entre les épanouissements 28, 30.

Des boulons 33 sans contact avec les parties métalliques traversent les cales 32 et servent à serrer les deux demi-cages 13, 14 entre elles.

L'eau de réfrigération entre par une arrivée 34 en bas du demi-anneau de droite 27 de la demi-cage inférieure 14, elle sort par une sortie 35 située en haut du demi-anneau de gauche 26. Cette sortie 35 est reliée une entrée 36 située en bas du demi-anneau de gauche 24 de la demi-cage supérieure 13 par une canalisation souple 37. L'eau sort finalement par une sortie 38 située en haut du demi-anneau de droite 25 de la demi-cage supérieure 13.

Pour fixer le potentiel de la demi-cage supérieure 13 on réunit cette dernière à la demi-cage inférieure 14 par une liaison électrique à très forte résistance 39.

Cette liaison en raison de sa très forte résistance ne transmet pas les courants variables qui naissent dans la demi-cage supérieure 13.

Pour faire les essais du rotor 8, on ferme la fosse puis on entraine en rotation le rotor excité. Le champ magnétique tournant créé est arrêté par la cage 12, 12' et, pour des mailles rectangulaires ayant une longueur de 1 m (distance entre deux conducteurs demi-circulaires) et une largeur de 40 cm (distance entre deux conducteurs axiaux), le champ magnétique à 50 cm de distance de la cage devenu inoffensif.

Les conducteurs 22 sont en alliage bon conducteur de l'électricité et les calories générées par effets Joule sont évacuées par l'eau de réfrigération.

Le flux de fuite qui passe entre les épanouissements 28, 30 en regard des deux demi-cages 13, 14 est très faible en raison de la proximité desdits épanouissements 28, 30. De plus à la sortie des épanouissements 28, 30 il se déconcentre et diverge sans produire d'effet nocif.

Ce flux induit deux nappes de courant de signe contraire dans les deux épanouissements en regard 28, 30 mais, comme la chute de potentiel magnétique le long du joint (de V à O) est la même qu'en suivant le quart de circonférence jusqu'au diamètre vertical, il en résulte que la somme des courants induits dans un épanouissement 28 est égale et de signe contraire à la somme des courants induits dans le quart de circonférence adjacent, ce qui assure un retour des courants sans traversée du joint.

Dans l'exemple de la figure 1 on a pris une cage courte 12' et une cage longue 12. Les deux cages 12, 12' ont été disposées côte à côte et leur longueur totale est légèrement supérieure à la longueur du rotor 8 produisant le champ. Ainsi tout l'environnement métallique du rotor en particulier les supports de palier 10 et les glissières 11 sont protégés.

**Revendications**

1. Dispositif de protection des objets métalliques situés dans l'environnement d'un grand champ magnétique développé par un rotor d'alternateur (8) sans stator au cours d'essais lorsqu'il est parcouru par un courant d'excitation, comportant une enveloppe métallique en plusieurs parties entourant le rotor (8) caractérisé en ce que l'enveloppe est constituée par au moins une cage métallique (12) formant un réseau maillé, chaque cage (12) étant composée d'une demi-cage inférieure (14) supportée par un socle (15) et d'une demi-cage supérieure (13) posée sur la demi-cage inférieure (14), les deux demi-cages (13, 14) étant assemblées dans un plan de joint horizontal, chaque demi-cage (13, 14) comprenant des éléments conducteurs de l'électricité horizontaux parallèles à l'axe du rotor (8) réunis et soudés à des éléments conducteurs de l'électricité demi-circulaires, ladite cage (12) ou lesdites cages (12, 12') placées bout à bout ayant une longueur supérieure à la partie du rotor (8) produisant le champ magnétique, lesdits conducteurs horizontaux étant des tubes parcourus par une circulation d'eau et débouchant aux deux extrémités dans des demi-anneaux creux servant de collecteurs hydrauliques pour l'entrée et la sortie de l'eau de réfrigération.

2. Dispositif de protection selon la revendication 1, caractérisé en ce que les deux demi-cages (13, 14) constituant chaque cage (12) sont prolongées dans le plan de joint par deux épanouissements (28, 30) lesdits épanouissements (28, 30) étant équipés de tubes auxiliaires (29, 31) débouchant dans des prolongements des demi-anneaux creux (24, 25, 26, 27) et étant entretoisés par des prolongements horizontaux des éléments conducteurs demi-circulaires (23) les épanouissements (28) de la demi-cage supérieure (13) étant séparés des épanouissements (30) de la demi-cage inférieure (14) par des moyens isolants électriques (32).

3. Dispositif de protection selon la revendication 2, caractérisé en ce que le serrage entre demi-cage inférieure (14) et demi-cage supérieure (13) est assuré par des cales isolantes (32) disposées entre les tubes (29, 31, 21) des épanouissements (28, 30), lesdites cales (32) étant maintenues par des boulons métalliques (33) sans contact avec les parties conductrices.

4. Dispositif de protection selon l'une des revendications précédentes, caractérisé en ce que la circulation de l'eau dans la demi-cage inférieure (14) se fait du point bas d'un demi-anneau creux (27) au point haut de l'autre demi-anneau creux (26) puis dans la demi-cage supérieure (13) d'un point bas d'un demi-anneau creux (24) au point haut de l'autre demi-anneau creux (25) ledit point haut du demi-anneau (26) de la demi cage inférieure (14) étant relié par une canalisation courte (37) audit point bas du demi-anneau creux (24) de la demi-cage supérieure (13).

5. Dispositif de protection selon l'une des revendications précédentes, caractérisé en ce qu'une liaison électrique (39) avec très forte résistance est disposée entre demi-cage inférieure (14) et demi-cage supérieure (13) permettant de mettre le potentiel de la demi-cage supérieure (13) à la masse.

**Patentansprüche**

1. Schutzvorrichtung für metallische Gegenstände, die sich in der Umgebung eines starken Magnetfeldes befinden, das von einem Rotor (8) eines Wechselstromgenerators ohne Stator im Verlauf von Tests erzeugt wird, wenn er von einem Erregerstrom durchflossen wird, wobei die Schutzvorrichtung eine Metallhülle aus mehreren Teilen aufweist, die den Rotor (8) umgibt, dadurch gekennzeichnet, daß die Metallhülle aus mindestens einem Metallkäfig (12), der ein Maschennetz bildet, besteht, wobei jeder Käfig (12) aus einem unteren Halbkäfig (14), der von einem Sockel (15) getragen wird, und aus einem oberen Halbkäfig (13) besteht, der auf den unteren Halbkäfig (14) aufgesetzt ist, daß die beiden Halbkäfige (13, 14) in einer waagerechten Verbindungsebene miteinander verbunden sind, wobei jeder Halbkäfig (13, 14) waagerechte Elektrizitätsleiterelemente parallel zur Achse des Rotors (8) aufweist, die mit halbkreisförmigen Elektrizitätsleiterelementen verbunden und verschweißt sind, daß der Käfig (12) oder die hintereinander angeordneten Käfige (12, 12') eine Länge aufweisen, die größer als der Teil des Rotors (8) ist, der das Magnetfeld erzeugt, und daß die waagerechten Leiter Rohre sind, die von einer Wasserzirkulation durchflossen werden und an beiden Enden in hohlen Halbringen enden, die als hydraulische Kollektoren für den Eingang und den Ausgang des Kühlwassers dienen.

2. Schutzvorrichtung nach Anspruch 1, dadurch gekennzeichnet, daß die beiden Halbkäfige (13, 14), die jeden Käfig (12) bilden, in der Verbindungsebene durch zwei Vorsprünge (28, 30) verlängert sind, die mit Hilfsrohren (29, 31) versehen sind, die in Verlängerungen der hohlen Halbringe (24, 25, 26, 27) münden und durch waagerechte Verlängerungen der halbkreisförmigen Leiterelemente (23) verstärkt sind, wobei die Vorsprünge (28) des oberen Halbkäfigs (13) von den Vorsprüngen (30) des unteren Halbkäfigs (14) durch elektrische Isoliermittel (32) getrennt sind.

3. Schutzvorrichtung nach Anspruch 2, dadurch gekennzeichnet, daß das Zusammenpressen zwischen unterem Halbkäfig (14) und oberem Halbkäfig (13) über Isolierpflöcke (32) erfolgt, die zwischen den Rohren (29, 31, 21) der Vorsprünge (28, 30) angeordnet sind, wobei die Pflöcke (32) von Metallbolzen (33) ohne Kontakt mit den leitenden Teilen gehalten werden.

4. Schutzvorrichtung nach einem der vorhergehenden Ansprüche, dadurch gekennzeichnet, daß die Wasserzirkulation im unteren Halbkäfig (14) von dem tiefen Punkt eines hohlen Halbrings (27) bis zum hohen Punkt des anderen hohlen Halbrings (26) und dann in dem oberen Halbkäfig (13) von einem tiefen Punkt eines hohlen Halbrings (24) bis zum hohen Punkt des anderen hohlen Halbrings (25) verläuft, wobei der hohe Punkt des Halbrings (26) des unteren Halbkäfigs (14) über eine kurze Leitung (37) mit dem tiefen Punkt des hohlen Halbrings (24) des oberen Halbkäfigs (13) verbunden ist.

5. Schutzvorrichtung nach einem der vorhergehenden Ansprüche, dadurch gekennzeichnet, daß eine elektrische Verbindung (39) mit sehr hohem Widerstand zwischen dem unteren Halbkäfig (14) und dem oberen Halbkäfig (13) angeordnet ist, die es ermöglicht, das Potential des oberen Halbkäfigs (13) an Masse zu legen.

## Claims

1. A device for protecting metal objects situated in the environment of an intense magnetic field developped by an alternator rotor (8) with an excitation current passing therethrough during testing without a stator, the device comprising a multipart metal covering surrounding the rotor (8), characterized in that the covering is constituted by at least one metal cage (12) forming a mesh-grid, each cage (12) being made up from a lower half cage (14) which is supported on a base (15) and an upper half cage (13) which is placed on the lower half cage (14), the two half cages (13, 14) meeting along a horizontal joint plane, each half cage (13, 14) comprising horizontal electrically conductive elements extending parallel to the rotor (8) axis and welded and joined to electrically conductive semi-circular elements, said cage (12), or said cages (12, 12') when placed end-to-end, being longer than the portion of the rotor (8) which produces the magnetic field, said horizontal conductors being tubes through which cooling water circulates and which end et the two sides in hollow half-rings serving as hydraulic manifolds for inlet and outlet of cooling water.

2. A protection device according to claim 1, characterized in that the two half cages (13, 14) constituting each cage (12) project in the joint plane in the form of two flanges (28, 30) comprising auxiliary tubes (29, 31) opening out into extensions of the hollow half-rings (24, 25, 26, 27) and being held in place by horizontal extensions of the semi-circular electrically conductive elements (23), the flanges (26) of the upper half cage (13) being separated from the flanges (30) of the lower half cage (14) by electrically insulating means (32).

3. A protection device according to claim 2, characterized in that the upper (13) and lower half cages (14) are tightened together via insulating blocks (32) disposed between the tubes (29, 31, 21) of the flanges (28, 30), said blocks (32) being held by metal bolts (33) without contact with the conductive parts.

4. A protections device according to any one of the preceding claims, characterized in that the cooling water circulates through the lower half cage (14) from the low point of a hollow half ring (27) to the high point of the other hollow half ring (26), and then through the upper half cage (13) from a low point of a hollow half ring (24) to the high point of the other hollow half ring (25), said high point of the half ring (26) of the lower half cage (14) being connected by a short duct (37) to said point of the hollow half ring (24) of the upper half cage (13).

5. A protection device according to any one of the preceding claims, characterized in that a very high resistance electrical connection (39) is provided between the lower half cage (14) and the upper half cage (13) allowing the potential of the upper half cage (13) to be connected to earth.

FIG.1

# FIG.2

# FIG.3